Europäisches Patentamt

(19) **European Patent Office**

Office européen des brevets

(11) Numéro de publication: **0 004 872**
**B1**

(12) **FASCICULE DE BREVET EUROPEEN**

(45) Date de publication du fascicule de brevet: **28.10.81**

(21) Numéro de dépôt: **79100817.0**

(22) Date de dépôt: **16.03.79**

(51) Int. Cl.³: **H 01 L 21/306,**
**C 09 K 13/00**

(54) Solution de décapage de tranches de silicium, présentant une vitesse de décapage déterminée et procédé en résultant.

(30) Priorité: **24.04.78 US 899051**

(43) Date de publication de la demande:
**31.10.79 Bulletin 79/22**

(45) Mention de la délivrance du brevet:
**28.10.81 Bulletin 81/43**

(84) Etats Contractants Désignés:
**DE FR GB**

(56) Documents cités:
**DE - A - 1 953 665**

**JOURNAL OF THE ELECTROCHEMICAL SOCIETY, volume 114, no. 9, septembre 1967 PRINCETON (USA) R. M. FINNE et al. "A Water-Amine-Complexing Agent System for etching Silicon", pages 965—970**

**JOURNAL OF THE ELECTROCHEMICAL SOCIETY, volume 125, no. 8, août 1978 PRINCETON (USA) A. REISMAN et al. "The Controlled Etching of Silicon in Catalyzed Ethylene Diamine-Pyrocatechol-Water Solutions", page 3510**

(73) Titulaire: **International Business Machines Corporation Armonk, N.Y. 10504 (US)**

(72) Inventeur: **Berkenblit, Melvin 2232 Ridge Street Yorktown Heights New York 10598 (US)** Inventeur: **Green, Dennis Clinton 10 Hillcrest Drive Peekskill New York 10566 (US)** Inventeur: **Kaufman, Frank Benjamin 500 East 85th Street New York 10028 (US)** Inventeur: **Reisman, Arnold 2294 VanCortland Circle Yorktown Heights New York 10598 (US)**

(74) Mandataire: **Klein, Daniel COMPAGNIE IBM FRANCE Département de Propriété Industrielle F-06610 La Gaude (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

# Solution de décapage de tranches de silicium, présentant une vitesse de décapage déterminée et procédé en résultant

Domaine Technique

La présente invention concerne une solution de décapage et un procédé permettant de commander la vitesse de décapage de tranches semi-conductrices, notamment en silicium. Elle concerne plus particulièrement une solution de décapage quaternaire contenant de l'éthylène-diamine, de l'eau, de la pyrocatéchine et des diazines, la quantité de ces dernières étant commandée, selon la vitesse de décapage désirée.

Etat de la technique

La technique de décapage du silicium qui fait appel à l'emploi d'un décapant composé d'eau, d'une amine et de pyrocatéchine est bien connue. Ce mélange est particulièrement utile car il permet d'obtenir un décapage anisotrope. L'article de R. M. Finne et de D. L. Klein intitulé "A Water-Amine Complexing Agent System for Etching Silicon", paru dans la publication "J. Electrochem. Soc.", *114*, 965, (1967), décrit les possibilités offertes en matière de décapage par des mélanges ternaires, d'eau, d'amine et d'un agent de complexation. Les auteurs dudit article on constaté qu'un tel mélange constituait un décapant anisotrope satisfaisant dans le cas du silicium, et que l'eau était l'élément qui permettait de commander la vitesse de décapage.

Par ailleurs, ainsi qu'il est indiqué dans la publication intitulée "Industrial Research", page 17, août 1977, un décapant à base d'eau, d'amine et de pyrocatéchine permet de décaper des rainures en forme de V dans des tranches de silicium découpées de manière à faire un angle déterminé par rapport à leurs orientations cristallines. Ce décapant convient particulièrement bien à la formation de "mesas" dans des dispositifs semi-conducteurs et de buses en silicium ces dernières étant destinées à être utilisées dans des imprimantes du type à projection d'encre (cf. le brevet des E.U.A. No. 3 974 769). La fabrication reproductible de tels éléments exige un contrôle constant de la composition du bain de décapage. Par exemple, il est extrêmement important de commander la vitesse de décapage du bain afin que les géométries des microstructures à décaper soient maintenues de façon reproductible dans les tolérances désirées.

C'est pourquoi, il est important que la vitesse de décapage et par conséquent la composition du bain, soient identiques d'un bain au suivant.

On a d'autre part constaté dans le cadre de la présente invention que la vitesse de décapage du silicium variait de façon inexplicable lors de l'emploi de différents lots d'amine, en fait de l'éthylène diamine. En effet, on a constaté que la vitesse de décapage présentait des variations importantes lors de l'emploi d'éthylène-diamine fournie par différents fabricants, en dépit du fait que des quantités identiques d'amine aient été employées dans chaque bain. De telles variations ne peuvent pas être tolérées si l'on veut obtenir une uniformité de la fabrication des dispositifs.

Exposé de l'invention

La présente invention supprime les incertitudes afférentes aux décapants ternaires de l'art antérieur grâce à l'emploi d'un procédé qui permet de déterminer et donc de commander la vitesse de décapage d'un décapant donné. En commandant la quantité de diazines présentes dans le décapant, on peut dorénavant obtenir une même vitesse de décapage, d'un bain à l'autre. Ce résultat est obtenu en ajoutant des diazines à différents lots d'éthylène-diamine de telle sorte que tous les lots présentent une quantité équivalente de diazine.

D'autre part, dans la plage ici définie de concentrations de diazine, on peut modifier la vitesse de décapage sans avoir à modifier la température, étant donné que ces composés en faibles quantités agissent en tant que catalyseur, l'importance de la catalyse et, par conséquent, la vitesse de décapage seront fonction de la concentration du catalyseur.

Etant donné que les lots reçus d'éthylène-diamine peuvent ou non comporter des traces de diazine, ils peuvent être examinés par spectrophotométrie aux rayons ultraviolets pour déterminer la quantité de diazines présentes. Ainsi l'emploi de ce type de spectrophotométrie permet de contrôler avec précision la concentration des diazines dans l'éthylène-diamine.

Ainsi la présente invention peut être décrite comme étant une solution de décapage notamment de tranches de silicium comprenant de l'éthylène-diamine, de la pyrocatéchine et de l'eau, ladite éthylène-diamine comportant en dissolution une quantité prédéterminée de pyrazine.

En outre, la présente invention peut également être définie comme un procédé de décapage de tranches de silicium qui comprend les étapes suivantes:

a) préparation d'une solution de décapage quaternaire comprenant de l'éthylène-diamine, de la pyrocatéchine, une diazine et de l'eau, la quantité de diazine présente étant commandée avec précision, et

b) application de la solution de décapage aux tranches de silicium à une température et pendant un intervalle de temps suffisants pour obtenir la configuration de décapage désirée.

Un premier objet de l'invention est de fournir une solution décapante quaternaire permettant d'obtenir un meilleur décapage du silicium.

Un autre objet de la présente invention est de fournir un procédé permettant de commander la vitesse de décapage du silicium au moyen d'une solution décapante quaternaire originale.

Comme on le verra par la suite, un avantage de la présente invention est de fournir un procédé qui permet de diminuer la sensibilité de la solution décapante à la chaleur, et qui permet en outre d'obtenir de meilleurs rapports de décapage anisotrope entre les orientations (100)/(111) des tranches de silicium.

Enfin, ce procédé permet d'obtenir une qualité de surface des tranches excellente.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 est un graphique représentant la densité optique d'une solution contenant de la 1,4-diazine et de l'éthylène-diamine en fonction de diverses concentrations de la 1,4-diazine.

La figure 2 représente schématiquement un dispositif de décapage utilisé pour les besoins de la présente invention.

La figure 3 est un graphique représentant la vitesse de décapage du silicium en fonction de la concentration de la 1,4-diazine.

La figure 4 est un graphique représentant le logarithme de la vitesse de décapage du silicium en fonction de la température.

La figure 5 est un graphique représentant le rapport de la vitesse de décapage pour du silicium monocristallin d'orientation (100) à la vitesse de décapage du silicium monocristallin d'orientation (111) en fonction de la concentration de la 1,4-diazine.

Description d'un mode de réalisation

On a constaté que les rapports de décapage obtenus dans le cas de solutions de décapage composées en parties égales d'éthylène-diamine, de pyrocatéchine et d'eau variaient en fonction du lot dont provenait l'éthylène-diamine. En d'autres termes, la vitesse de décapage variait en fonction du vendeur de l'éthylène-diamine. De telles variations ne peuvent pas être tolérées si l'on veut obtenir des microstructures reproductibles. En examinant différents lots d'éthylène-diamine au moyen de techniques chromatographiques et spectro-photométriques à rayons ultraviolets, on a observé la présence de la 1,4-diazine (pyrazine) en tant que contaminant en quantités variables, celles-ci allant d'environ zéro ppm à environ 2000 ppm par litre d'éthylène-diamine. On a également observé que l'emploi de solutions de décapage préparées avec de l'éthylène-diamine comportant des quantités variables de 1,4-diazine se traduisait par des vitesses de décapage variables.

On avait alors découvert que la vitesse de décapage obtenue lors de l'emploi d'un décapant ternaire classique composé d'éthylène-diamine, de pyrocatéchine et d'eau pouvait être commandée en ajoutant à ce décapant un quatrième composant, à savoir une diazine.

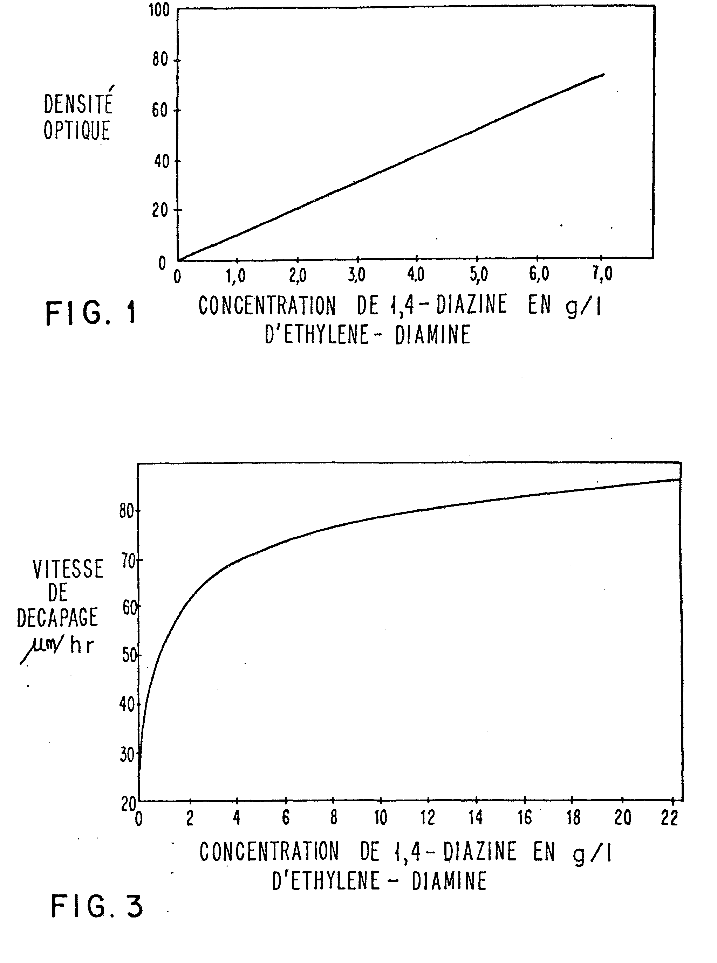

La figure 1 montre la densité optique de l'éthylène-diamine contenant diverses quantités de 1,4-diazine. Dans le présent procédé, des quantités désirées d'une diazine sont ajoutées à l'éthylène-diamine et sont contrôlées au moyen de la technique d'absorption en ultraviolet à une valeur de pointe caractéristique, à savoir 315 nm (3150 Å) pour la 1,4-diazine, pour la solution, ce qui permet d'ajouter des quantités bien déterminées de diazine.

Dans la pratique de la présente invention, une diazine choisie dans le groupe constitué par la 1,2-diazine, la 1,4-diazine ou leurs dérivés tels que la phthalazine, la pyridopyrazine, la phénazine, la 2,5-diméthylpyrazine, la 2,6-diméthylpyrazine, la tétramémylpyrazine et la phénylpyrazine, est ajoutée à de l'éthylène-diamine en quantités comprises entre 2g environ et 4g environ par litre d'éthylène-diamine, selon la vitesse de décapage désirée et la température à laquelle le décapage doit être effectué. La concentration préférée de la diazine est comprise entre 2,5g environ et 3g environ par litre d'éthylène-diamine.

La solution de décapage utilisée dans la présente invention est préparée en ajoutant de 700 à 800ml environ d'éthylène-diamine dans laquelle une diazine est dissoute à raison de 2 à 4g par litre d'éthylène-diamine, à une solution contenant de 100 à 150g environ de pyrocatéchine et de 200ml à 250ml environ d'eau.

Le décapage est généralement effectué dans une plage de températures allant de 100°C environ au point d'ébullition à 119°C environ (selon la composition exacte). La plage préférée de températures va de 110°C à 115°C environ.

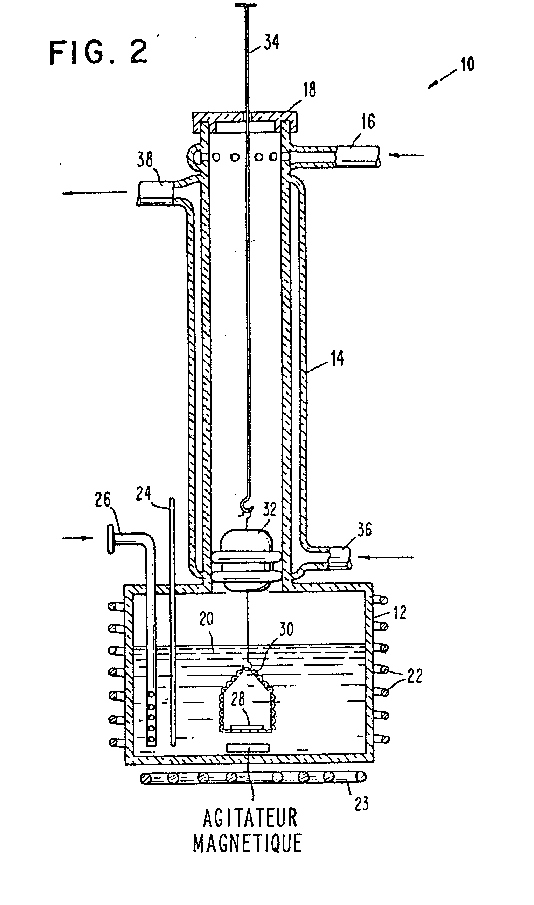

Dans la pratique de la présente invention, la solution de décapage précitée est disposée dans un appareil du type représenté sur la figure 2.

Ledit appareil, référencé 10, est entièrement réalisé en quartz et sa hauteur est d'environ 80cm. Sa partie inférieure 12 peut contenir un litre environ de la solution de décapage 20. Sa partie supérieure comporte un condenseur 14 refroidi par eau et un orifice 16 d'admission d'argon qui fait fonction de barrière gazeuse pour empêcher la rétrodiffusion de l'oxygène dans le système. L'appareil est fermé au moyen d'un couvercle 18, qui est disposé au-dessus de l'orifice d'admission d'argon 16 et soutient le panier 30 et le déflecteur 32. La température de la solution de décapage 20 qui se trouve dans la partie inférieure 12 de l'appareil est maintenue à une valeur déterminée au moyen d'éléments chauffants 22 et 23. Cette température est contrôlée à plus ou moins 0,1°C près par un thermocouple 24 relié à une unité de commande (non représentée). Les éléments 22 sont disposés sur les côtés de l'appareil et fournissent une chaleur qui s'ajoute à celle produite par l'élément 23, cette dernière peut être constitué par une plaque chauffante se trouvant dans la partie inférieure de l'appareil, de manière à réduire les gradients thermiques dans la solution 20. Des bulles sont formées dans la solution 20 par l'intermédiaire d'un dispositif 26 alimenté en argon ou autre gaz inerte. Le débit d'argon est maintenu à environ 20cm³/min. Un débit d'argon de 500cm³/min est maintenu au niveau de l'orifice d'admission 16 de façon à éviter que l'air ne contamine le bain lors de l'introduction d'une tranche de silicium 28 dans l'appareil ou de son retrait de ce dernier. La tranche 28 est suspendue dans la solution 20 au moyen d'un panier en platine 30. Un déflecteur en quartz 32 est suspendu au niveau de la jonction de la partie inférieure 12 avec le condenseur 14, de manière à éviter tout refroidissement inutile de la solution 20 par convevtion. Le déflecteur 32 est suspendu au moyen d'un fil de platine 34. L'eau destinée au condenseur est introduite dans celui-ci par l'orifice 36 et en sort par l'orifice 38.

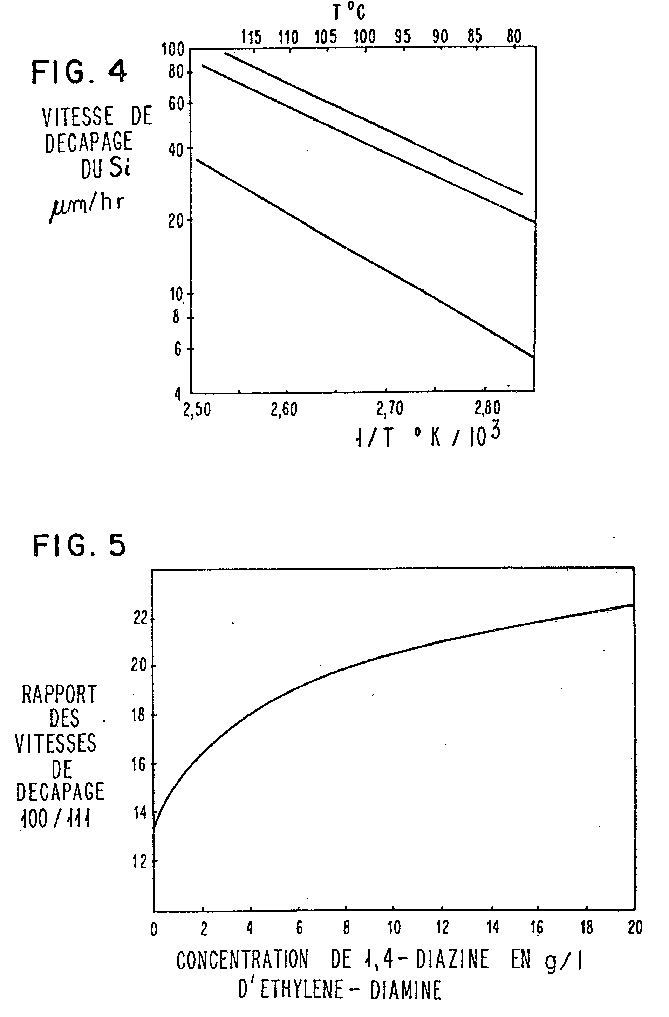

Des tranches de silicium d'environ 57mm, de type p et d'orientation (100), ont été décapées en utilisant l'appareil 10 et des solutions de décapage typiques composées de 750ml d'éthylène-diamine, de 120g de pyrocatéchine et de 240ml d'eau. On a ajouté à cette solution des quantités de 1,4-diazine comprises entre 0g et 20g environ. La température a été maintenue à 115°C environ. Généralement, le décapage est effectué en l'absence d'air, ce résultat étant obtenu en faisant circuler de l'argon dans l'appareil 10. L'air est exclu de manière à prévenir le vieillissement de la solution de décapage. En effet, l'air ou l'oxygène provoque une augmentation incontrôlable et imprévisible de la solution de décapage s'il entre en contact avec celle-ci, particulièrement à des températures élevées. La figure 3 montre les variations de la vitesse de décapage des tranches de silicium en fonction de la concentration de la 1,4-diazine. Ces données peuvent être utilisées aux fins d'un second procédé plus précis permettant de calibrer la concentration de 1,4-diazine dans de nouveaux lots d'éthylène-diamine.

Cette figure 3 montre que la variation la plus rapide de la vitesse de décapage se produit entre 0g et 1g de la 1,4-diazine. Au-dessus de 2g, la variation de la vitesse de décapage diminue au fur et à mesure que l'on augmente la concentration de la 1,4-diazine. On obtient ensuite une courbe presque linéaire, avec une variation d'environ 1$\mu$m/heure par gramme supplémentaire de 1,4-diazine/litre d'éthylène-diamine. Cependant, on a observé pendant l'expérience ci-dessus que, lorsque la concentration de la 1,4-diazine dépassait 4 ou 5g, on obtenait une quantité inacceptable d'un résidu insoluble. La concentration préférée de la 1,4-diazine varie par conséquent entre 2 et 4g par litre d'éthylène-diamine.

Une étude comparative des effets sur la vitesse de décapage de la présence d'une diazine a été effectuée en utilisant des bains typiques décrits plus haut. Un bain ne comportant pas de diazine a été préparé, de même que deux autres bains auxquels on a respectivement ajouté de la 1,4-diazine et de la 1,2-diazine à raison de 5g par litre d'éthylène-diamine. Les vitesses de décapage des solutions respectivement obtenues étaient de 26, de 72 et 81$\mu$m/heure. Cela prouve l'influence positive, de la présence d'une diazine sur la vitesse de décapage de la solution.

En outre dans la plage préférée de concentrations de la 1,4-diazine, on constate une diminution de la sensibilité aux fluctuations de la température.. C'est ce que montre la figure 4, où on a représenté les vitesses de décapage (exprimées au moyen d'une échelle logarithmique), en fonction de la température. L'énergie d'activation de la réaction peut être déterminée en fonction de la pente des courbes. Par exemple, en l'absence de 1,4-diazine (la courbe du bas), l'énergie d'activation est d'environ 10,8 Kcal/mole (0,47 eV); en présence de 2,1g de 1,4-diazine par litre d'éthylène-diamine, cette énergie d'activation est de 8,4 Kcal/mole (0,36 eV). Cette diminution d'énergie équivaut à une diminution de la sensibilité aux variations de température, ce qui permet d'obtenir des vitesses de décapage plus uniformes et, par conséquent, des produits définitifs plus uniformes.

L'addition d'une diazine à la solution de décapage offre l'avantage supplémentaire important d'améliorer le rapport des vitesses de décapage anisotrope de surfaces présentant une orientation (100) aux vitesses de décapage anisotrope de surfaces présentant une orientation (111). Par exemple, lorsqu'on décape du silicium afin d'obtenir des buses destinées à une imprimante du type à projection d'encre dans une surface d'orientation (100), il y a intérêt à ce que la vitesse de décapage soit élevée pour cette surface et aussi faible que possible pour les surfaces des parois présentant une orientation (111). Cela permet de réduire au minimum le décapage latéral et les erreurs dimensionnelles dans le produit finalement obtenu. La figure 5 est un graphique représentant le rapport des vitesses de décapage anisotrope pour des surfaces d'orientation (100)/(111) en fonction de la concentration de la 1,4-diazine, et permet de constater que la valeur de ce rapport augmente en fonction de l'augmentation de cette concentration.

Le décapant de la présente invention offre un autre avantage. On a vu que, lorsque la quantité de 1,4-diazine présente est comprise entre 2 et 4g environ par litre d'éthylène-diamine, il se produit une nette amélioration de la qualité de la surface du silicium, laquelle comporte moins de piqûres et de microstructures (défauts). On observe au contraire la présence de piqûres et de défauts lorsque la solution de décapage ne comporte pas de diazine.

La présente invention permet, entre autres avantages, d'obtenir des vitesses de décapage reproductibles au moyen de bains de décapage préparés à partir de différents lots d'éthylène-diamine ou à partir d'éthylène-diamine commercialisés par différents fabricants. La solution de décapage de l'invention présente une sensibilité moindre aux variations de température et un meilleur rapport des vitesses de décapage anisotrope de surfaces d'orientation (100)/(111), et permet enfin d'obtenir une surface de meilleure qualité.

La présente invention est donc destinée à trouver application dans la fabrication des transistors de champ de type V-MOS, de buses en silicium pour imprimantes à jet d'encre, etc.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Solution de décapage de tranches de silicium comprenant de l'éthylène-diamine, de la pyrocatéchine et de l'eau, caractérisée en ce qu'elle comprend une quantité prédéterminée d'une diazine.

2. Solution selon la revendication 1, caractérisée en ce que la quantité de diazine présente varie entre 2g et 4g environ par litre d'éthylène-diamine.

3. Solution selon la revendication 1 ou 2, caractérisée en ce que ladite solution de décapage contient de 700 à 800ml environ d'éthylène-diamine, de 200 à 250ml environ d'eau, de 100 à 150g environ de pyrocatéchine, et de 2 à 4g environ d'une diazine par litre d'éthylène-diamine.

4. Solution selon la revendication 3, caractérisée en ce que ladite solution de décapage comprend 750ml d'éthylène-diamine, 240ml d'eau et 120g de pyrocatéchine, de la diazine étant dissoute dans ladite solution d'éthylène-diamine à raison de 2,5g par litre d'éthylène diamine.

5. Solution selon l'une des revendications 1 à 4, caractérisée en ce que la diazine est choisie dans le groupe composé des matériaux suivants: 1,4-diazine, 1,2-diazine, phthalazine, pyridopyrazine, phénazine, 2,5-diméthylpyrazine, 2,6-diméthylpyrazine, tétraméthyl-pyrazine et phénylpyrazine.

6. Solution selon la revendication 5, caractérisée en ce que ladite diazine est de la 1,4-diazine.

7. Solution selon la revendication 5, caractérisée en ce que ladite diazine est de la 1,2-diazine.

8. Procédé de décapage de tranches de silicium caractérisé en ce qu'il comporte les étapes suivantes:
1) élaboration d'une solution de décapage telle que définie par l'une quelconque des revendications ci-dessus, et
2) mise en contact de ladite solution de décapage aves le silicium à une température et pendant un intervalle de temps suffisants pour obtenir la configuration de décapage désirée.

## Claims

1. Solution for etching silicon wafers comprising ethylene-diamine, pyrocatechol and water, characterized in that it contains a predetermined quantity of a diazine.

2. Solution according to claim 1, characterized in that the quantity of diazine contained varies from about 2g to 4g per litre of ethylene-diamine.

3. Solution according to claim 1 or 2, characterized in that said etchant solution contains from about 700ml to 800ml of ethylene-diamine, from about 200ml to 250ml of water, from about 100g to 150g of pyrocatechol, and from about 2g to 4g of a diazine per litre of ethylene-diamine.

4. Solution according to claim 3, characterized in that said etchant solution contains 750ml of ethylene-diamine, 240ml of water, and 120g of pyrocatechol, diazine being dissolved in said ethylene-diamine solution in the amount of 2.5g per litre of ethylene-diamine.

5. Solution according to any one of claims 1 to 4, characterized in that the diazine is selected from the group consisting of the following materials: 1,4-diazine, 1,2-diazine, phthalazine, pyridopyrazine, phenazine, 2,5-dimethylpyrazine, 2,6-dimethylpyrazine, tetramethyl-pyrazine, and phenylpyrazine.

6. Solution according to claim 5, characterized in that said diazine is a 1,4-diazine.

7. Solution according to claim 5, characterized in that said diazine is a 1,2-diazine.

8. Method for etching silicon wafers, characterized in that it includes the following steps:
1) Preparing an etchant solution such as defined in any one of the above-mentioned claims, and
2) Applying said etchant solution to the silicon at a temperature and for a duration sufficient to obtain the desired etching configuration.

## Patentansprüche

1. Lösung zum Ätzen von Siliciumplättchen aus Äthylendiamin, Pyrocatechol und Wasser, dadurch gekennzeichnet, daß sie eine vorbestimmte Menge an Diazin enthält.

2. Lösung nach Anspruch 1, dadurch gekennzeichnet, daß die vorhandene Menge an Diazin zwischen ungefähr 2 g und 4 g pro Liter Äthylendiamin variiert.

3. Lösung nach Anspruch 1 oder 2, dadurch gekennzeichnet, daß die Ätzlösung ungefähr 700 ml bis 800 ml Äthylendiamin, ungefähr 200 ml bis 250 ml Wasser, ungefähr 100 g bis 150 g Pyrocatechol und ungefähr 2 g bis 4 g eines Diazins pro Liter Äthylendiamin enthält.

4. Lösung nach Anspruch 3, dadurch gekennzeichnet, daß die Ätzlösung 750 ml Äthylendiamin, 240 ml Wasser und 120 g Pyrocatechin enthält, wobei Diazin in der Äthylendiaminlösung aufgelöst wird, und zwar 2,5 g pro Liter Äthylendiamin.

5. Lösung nach einem der Ansprüche 1 bis 4, dadurch gekennzeichnet, daß das Diazin in der aus den folgenden Stoffen bestehenden Gruppe gewählt wird: 1,4-Diazin, 1,2-Diazin, Phthalazin, Pyridopyrazin, Phenazin, 2,5-Dimethylpyrazin, 2,6-Dimethylpyrazin, Tetramethylpyrazin und Phenylpyrazin.

6. Lösung nach Anspruch 5, dadurch gekennzeichnet, daß das Diazin ein 1,4-Diazin ist.

7. Lösung nach Anspruch 5, dadurch gekennzeichnet, daß das Diazin ein 1,2-Diazin ist.

8. Verfahren zum Ätzen von Siliciumplättchen, gekennzeichnet durch folgende Verfahrensschritte:

1) Herstellen einer Ätzlösung, wie sie in einem der obigen Ansprüche gekennzeichent ist, und

2) Auftragen der Ätzlösung auf das Silicium bei einer Temperatur und während einer Zeitspanne, die ausreicht, um das gewünschte Ätzmuster zu erhalten.

**0 004 872**

FIG. 1

DENSITÉ OPTIQUE

CONCENTRATION DE 1,4 – DIAZINE EN g/l D'ETHYLENE – DIAMINE

FIG. 3

VITESSE DE DECAPAGE μm/hr

CONCENTRATION DE 1,4 – DIAZINE EN g/l D'ETHYLENE – DIAMINE

FIG. 2

AGITATEUR
MAGNETIQUE

**0 004 872**

FIG. 4

VITESSE DE
DECAPAGE
DU Si

$\mu m/hr$

$1/T \quad °K \, / \, 10^3$

FIG. 5

RAPPORT
DES
VITESSES
DE
DECAPAGE
100 / 111

CONCENTRATION DE 1,4 – DIAZINE EN g / l
D'ETHYLENE – DIAMINE

3